# EUROPÄISCHE PATENTANMELDUNG

(11) **EP 0 643 550 A1**
(43) Veröffentlichungstag der Anmeldung: **15.03.1995**
(21) Anmeldenummer: 94202541.2
(22) Anmeldetag: 06.09.1994
(51) Int. Cl.: H05K 9/00, H05K 3/00

(54) **Kunststoffbauteil, z.B. Verdrahtungsträger oder Kunststoffgehäuse**

(30) Priorität: 10.09.1993 DE 4330713
(71) Anmelder: Philips Patentverwaltung GmbH, 22335 Hamburg (DE); PHILIPS ELECTRONICS N.V., 5621 BA Eindhoven (NL)
(72) Erfinder: Füchtenkort, Manfred, D-20097 Hamburg (DE)
(74) Vertreter: Erdmann, Anton, Dipl.-Ing.

(57) **Zusammenfassung**

Die Erfindung bezieht sich auf ein Kunststoffbauteil, z.B. auf ein Kunststoffgehäuse oder auf einen Verdrahtungsträger für Geräte der elektrischen Nachrichtentechnik, dessen Wände (15) mit mindestens teilweise metallisierten Kunststoffolien (16) fest verbunden sind. Dabei wird eine zuverlässige elektrische Abschirmung und eine einfache Möglichkeit zur Verdrahtung dadurch hergestellt, daß die Wände (15) mindestens zwei aufeinanderfolgende, fest miteinander verbundene metallisierte Kunststoffolien (16, 18) aufweisen und daß die den Wänden benachbarte erste Folie (16) mit einer vollflächigen metallischen Beschichtung (17) und die zweite Folie (18) an ihrer Außenseite mit einer bereichsweise ausgebildeten metallischen Beschichtung in Form von Leiterbahnen (19) versehen ist.

## Beschreibung

Die Erfindung bezieht sich auf ein Kunststoffbauteil, z.B. auf einen Verdrahtungsträger oder Kunststoffgehäuse für Geräte der elektrischen Nachrichtentechnik, dessen Wände mit mindestens teilweise metallisierten Kunststoffolien fest verbunden sind.

Eine derartige Bauweise ist durch die im Januar 1987 erschienene Veröffentlichung "Metalized Plastic Enclosure for EMC Shielding" bekannt geworden. Diese Entgegenhaltung beschreibt ein Verfahren zur vollständigen oder teilweisen Metallisierung von Kunststoffbauteilen, um diesen Bauteilen eine effektive und zuverlässige elektromagnetische Schirmwirkung zu verleihen. Dabei wird eine Plastikfolie oder eine Plastikplatte, passend in eine Form zur Herstellung der Kunststoffbauteile, an einer oder an beiden Seiten mit einer metallischen, leitenden Schicht versehen. Die Beschichtung kann z.B. erfolgen in einem Vakuumspritz- bzw. Vakuum-Sputterverfahren oder durch Sprühen, Rollen oder dergl.. Die metallisierte Folie kann dabei entweder vorgeformt und dann in die Form eingebracht oder in der Form selbst zusammen mit dem zu formenden Kunststoffbauteil geformt werden. Je nach Wunsch kann dabei die metallisierte Folie an der Außen- oder an der Innenseite des zu formenden Kunststoffbauteiles befestigt werden. Die Befestigung kann entweder durch Kohäsion oder durch Kleben, gegebenenfalls unter Zusatz eines besonderen Klebemittels, erfolgen. Die Metallschicht besteht in der Regel aus Kupfer und ist überlagert mit einer dünnen Nickelschicht, um einen geringen Kontaktwiderstand zu erzeugen.

Durch das DE-GM 92 01 594 ist ein aus zwei Kunststoffschalen hergestelltes Gehäuse für ein Telefongerät bekannt gewordne, das innenseitig mit einer durch Bedampfen oder Galvanisieren aufgebrachten metallischen Abschirmung versehen ist. Die durch Bedampfen oder Galvanisieren erzielbaren Dicken der Metallschichten reichen für eine erhöhte Anforderung in bezug auf die Abschirmung elektromagnetischer Felder nicht mehr aus. Ferner sind derartig dünne Metallschichten für Verdrahtungsfunktionen in solchen Kunststoffgehäusen nicht geeignet.

Dreidimensionale Leiterplatten (3D-MID-Leiterplatten) können z.B. in einem Zwei-Komponenten-Spritzgußverfahren oder in einem foto-chemischen Verfahren hergestellt werden. Bei dem Zwei-Komponenten-Spritzgußverfahren werden ein galvanisierbarer (für späteren Leiterbahnen) und ein nicht-galvanisierbarer Kunststoff in einem entsprechend ausgelegten Werkzeug verarbeitet. Durch die unterschiedlichen Eigenschaften der beiden Kunststoffe können bereichsweise die vorher in dem Werkzeug abgebildeten Bereiche des galvanisierbaren Kunststofftyps als Leiterbahnen über galvanische Prozesse erzeugt werden. Nachteile dieses Verfahrens sind die hohen Werkzeugkosten, die Unflexibilität bei Layout-Änderungen (Leiterbahnstrukturen müssen in der Spritzgußform abgebildet werden) und die damit verbundenen langen Vorlaufzeiten für die Formherstellung.
Ähnlich wie bei einer konventionallen Leiterplatte können auf gespritzten dreidimensionalen Kunststoffteilen aus bestimmten Basiswerkstoffen Leiterbahnstrukturen mit Hilfe eines fotochemischen Prozesses erzeugt werden. Neben der Einschränkung auf galvanisierbare Kunststofftypen stellt auch die Belichtung im dreidimensionalen Raum (Direktbelichtung über Laser, Belichtung über dreidimensionale Masken) hohe Anforderungen an die Prozeßtechnik und ist somit sehr kostenintensiv.

Der Erfindung liegt die Aufgabe zugrunde, ein Kunststoffbauteil, z.B. einen Verdrahtungsträger oder ein Kunststoffgehäuse, der eingangs genannten Art auf einfache Weise derart zu gestalten, daß auch die erhöhten Anforderungen an die Abschirmung elektromagnetischer Felder erfüllt werden und daß eine Verdrahtung von elektrischen Bauelementen vereinfacht werden kann.

Diese Aufgabe wird gemäß der Erfindung dadurch gelöst, daß die Wände mindestens zwei aufeinanderliegende, fest miteinander verbundene, metallisierte Kunststoffolien aufweisen und daß die den Wänden benachbarte erste Folie mit einer vollflächigen metallischen Beschichtung und die zweite Folie an ihrer Außenseite mit einer bereichsweise ausgebildeten metallischen Beschichtung in Form von Leiterbahnen versehen ist. Ein derartiges Kunststoffbauelement, z.B. ein Verdrahtungsträger bzw. ein Gehäuse, bietet sowohl eine wirksame Abschirmung gegenüber elektromagnetischen Feldern durch die vollflächige Beschichtung der ersten Folie als auch eine Möglilchkeit zur einfachen Verdrahtung von anzubringenden elektrischen Bauteilen durch die bereichsweise ausgebildeten Leiterbahnen. Dabei kann, je nach Stärke der zu erwartenden elektromagnetischen Strahlung, bei der Herstellung eine Folie mit entsprechend dicker metallischer Beschichtung gewählt werden. Es können z.B. ohne weitere metallische Schichtdicken von z.B. 30 µ, 50 µ oder 100 µ erzielt werden. Diese Dicken liegen deutlich höher als die z.B. bei einem HV-Bedampfungsverfahren erzielbaren Dicken. Die zweite Folie mit der bereichsweise in Form von Leiterbahnen aufgebrachten metallischen Beschichtung bedeutet eine in das Bauteil integrierte Verdrahtung, mit deren Hilfe an dem Bauteil, z.B. innerhalb Eines Gehäuses oder eines Verdrahtungsträgers, vorgesehene Bauelemente auf einfache Weise verdrahtet werden können. Eine derartige, partiell aufbringbare metallische Beschichtung ist vorteilhaft gegenüber der Galvanotechnik, mit deren Hilfe lediglich vollflächige Beschichtungen hergestellt werden können.

In Ausgestaltung der Erfindung ist vorgesehen, daß die vollflächige metallische Beschichtung der ersten Folie zwischen den beiden Folien angeordnet ist. Diese Bauweise ermöglicht einen wirksamen Schutz dieser metallischen Beschichtung gegen Beschädigungen von außen.

In weiterer Ausgestaltung der Erfindung werden vorzugsweise Folien aus wärmebeständigem, thermoplastischem Kunststoff, z.B. PE, PC, PI oder PA, verwendet, die mit einem Beschichtungsmaterial aus Aluminium und/oder Kupfer versehen sind.

Die metallisch beschichteten Folien werden z.B. entsprechend der Kontur des Kunststoffbauteiles, z.B. der Innenkontur eines Gehäuses oder Verdrahtungsträgers, vorgeformt, und zwar z.B. durch Tiefziehen in einer Tiefziehform.

In weiterer Ausgestaltung der Erfindung ist vorgesehen, daß die Leiterbahnstrukturen mit Hilfe eines foto-chemischen Prozesses aus einer vollflächigen metallischen Beschichtung erzeugt sind.

Die Wände des Kunststoffbauteiles sind vorzugsweise in einem Spritz-Guß-Verfahren aus thermoplastischem Kunststoff hergestellt.

Die Erfindung bezieht sich ferner auf ein Verfahren zur Herstellung eines Kunststoffbauteiles, wobei der Kunststoff in einem Spritz-Guß-Verfahren in eine Bauteilform eingebracht wird. Erfindungsgemäß werden dabei die aufeinanderliegenden, fest miteinander verbundenen Folien in die Bauteilform eingebracht, wobei die Verbindung zwischen den wandseitigen Folien und den Wänden des Kunststoffbauteiles beim Spritz-Guß-Prozeß erfolgt.

In der Zeichnung sind in Fig. 1 bis 5 Ausführungsbeispiele des Gegenstandes gemäß der Erfindung schematisch dargestellt.
Fig. 1 zeigt eine Folie aus thermoplastischem Kunststoff, die einseitig vollflächig mit einer elektrisch leitfähigen Beschichtung versehen ist,
Fig. 2 zeigt eine Folie gemäß Fig. 1 mit aus einer vollflächigen Schicht entstandenen Leiterbahnstrukturen,
Fig. 3 zeigt die Kombination einer ersten Folie mit einer vollflächigen Beschichtung und einer zweiten Folie mit einer partiellen Beschichtung,
Fig. 4 zeigt in zwei Teildarstellungen einen einbaufertigen Kunststoff Verdrahtungsträger als 3D-Leiterplatte mit einer vollflächig und mit einer bereichsweise beschichteten Folie, und
Fig. 5 zeigt in einer geschnittenen Teilansicht ein aus zwei Schalen gebildetes Gehäuse mit innenseitig liegenden, metallisch beschichteten Folie.

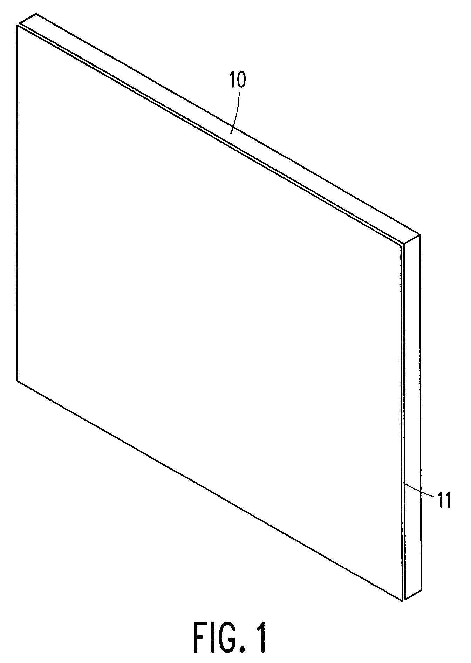

Gemäß Fig. 1 ist die Kunststoffolie 10 auf einer Seite mit einer elektrisch leitfähigen Beschichtung 11, z.B. aus Kupfer oder Aluminium, versehen. Die Folie 10 ist z.B. 200 µm und die Beschichtung 11 z.B. 30 µm dick.

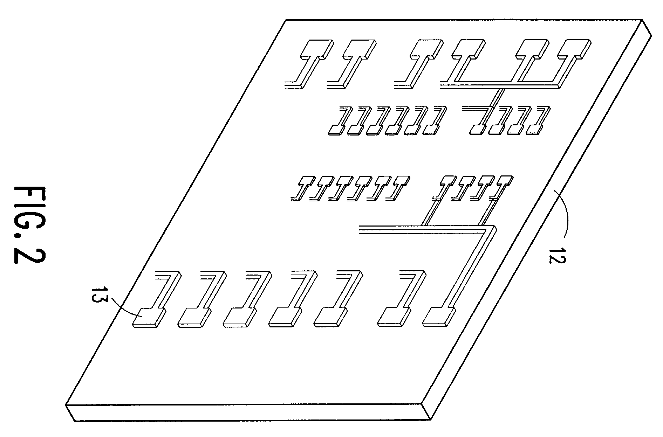

Fig. 2 zeigt eine Folie 12, bei der Leiterbahnstrukturen 13, z.B. durch Ätzen, aus einer vollflächigen Beschichtung 11 gemäß Fig. 1 entstanden sind.

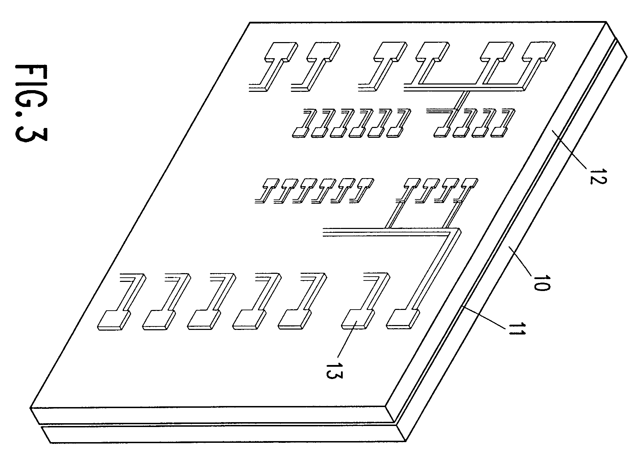

Fig. 3 zeigt eine Kombination der Folien 10 und 12 nach Fig. 1 und 2. Die Folie 10 mit der Beschichtung 11 ist fest mit der Folie 12 verbunden, die mit Leiterbahnstrukturen 13 versehen ist.

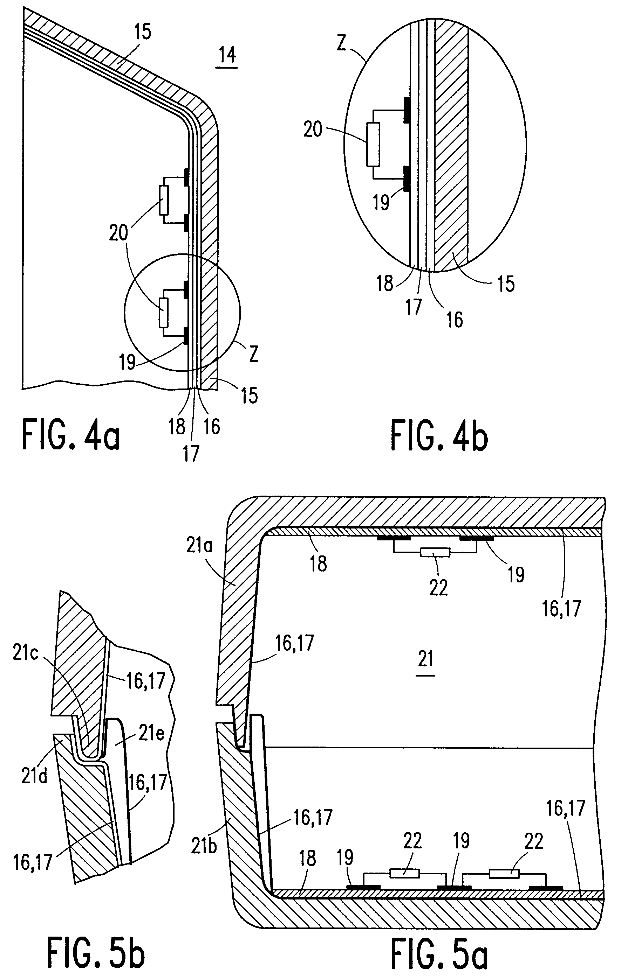

Fig. 4a und b zeigen eine dreidimensinale Leiterplatte 14 mit einer Kunststoffwand 15, die eine erste Kunststoffolie 16 mit einer vollflächigen Beschichtung 17 und eine zweite Kunststoffolie 18 mit einer bereichsweisen Beschichtung 19 aufweist. Die vollflächige Beschichtung 17 dient als Abschirmung und sitzt zwischen beiden Folien 16 und 18, wobei die erste Follie 16 an der Wand 15 befestigt ist. Die bereichsweise Beschichtung 19 ist als Leiterbahnstruktur ausgebildet und durch Ätzen aus einer vollflächigen Schicht entstanden. Auf den Leiterbahnen 19 sind Bauelemente 20 befestigt.

Fig. 5a zeigt ein zweischaliges Gehäuse 21 mit einer oberen Gehäuseschale 21a und einer unteren Gehäuseschale 21b mit jeweils innenseitig befestigen Folien 16, 18, die ganz bzw. bereichsweise mit elektrisch leitfähigen Beschichtungen 17 bzw. 19 versehen sind. Beim Zusammenbau gemäß Fig. 5b erfolgt eine direkte Kontaktierung der vollflächig beschichteten Folien 16, 17 im Bereich der Gehäuseteile 21c, d, e. Die ausgeprägten Leiterbahnen 19 dienen zur Verdrahtung von Bauelementen 22.

## Patentansprüche

1. Kunststoffbauteil, z.B. Verdrahtungsträger oder Kunststoffgehäuse für Geräte der elektrischen Nachrichtentechnik, dessen Wände (15) mit mindestens teilweise metallisierten Kunststoffolien (16) fest verbunden sind, dadurch gekennzeichnet, daß die Wände (15) mindestens zwei aufeinanderliegende, fest miteinander verbundene, metallisierte Kunststoffolien (16, 18) aufweisen und daß die den Wänden benachbarte erste Folie (16) mit einer vollflächigen metallischen Beschichtung (17) und die zweite Folie (18) an ihrer Außenseite mit einer bereichsweise ausgebildeten metallischen Beschichtung in Form von Leiterbahnen (19) versehen ist.

2. Kunststoffbauteil nach Anspruch 1, dadurch gekennzeichnet, daß die vollflächige Beschichtung (17) zwischen den beiden Folien (16, 18) angeordnet ist.

3. Kunststoffbauteil nach Anspruch 1 oder 2, gekennzeichnet durch die Verwendung einer Folie aus wärmebeständigem, thermoplastischem Kunststoff (z.B. Polyester, Polycarbonat, Polyimid oder Polyamid), die mit einem Beschichtungsmaterial (17, 19) aus Aluminium und/oder Kupfer versehen ist.

4. Kunststoffbauteil nach einem der Ansprüche 1 bis 3, dadurch gekennzeichnet, daß die metallisch beschichteten Folien (16, 18) entsprechend der Kontur des Kunststoffbauteiles, z. B. des Gehäuses oder des Verdrahtungsträgers, durch Tiefziehen in einer Tiefziehform vorgeformt sind.

5. Kunststoffbauteil nach einem der Ansprüche 1 bis 4, dadurch gekennzeichnet, daß die Leiterbahnstrukturen (19) mit Hilfe eines foto-chemischen Prozesses aus einer vollflächigen leitfähigen Beschichtung (11) erzeugt sind.

6. Kunststoffbauteil nach einem der Ansprüche 1 bis 5, dadurch gekennzeichnet, daß die Wände (15) des Kunststoffbauteiles aus thermoplastischem Kunststoff in einem Spritz-Guß-Verfahren hergestellt sind.

7. Verfahren zur Herstellung eines Kunststoffbauteiles nach einem der Ansprüche 1 bis 6, wobei der Kunststoff in einem Spritz-Guß-Prozeß in eine Bauteilform eingebracht wird, dadurch gekennzeichnet, daß die aufeinanderliegenden, fest miteinander verbundenen Folien (16, 18) in die Bauteilform eingebracht werden und daß die Verbindung zwischen den wandseitigen Folien (16) und den Wänden des Kunststoffbauteiles beim Spritz-Guß-Prozeß erfolgt.
